Europäisches Patentamt

European Patent Office

Office européen des brevets

(19)

(11) Publication number: **0 164 793**

**B1**

(12) **EUROPEAN PATENT SPECIFICATION**

(45) Date of publication of patent specification: **10.08.88**

(51) Int. Cl.⁴: **B 65 B 31/02**

(21) Application number: **85200816.8**

(22) Date of filing: **22.05.85**

(54) **Method for vacuum-packaging finely divided materials.**

(30) Priority: **23.05.84 IT 2105384**

(43) Date of publication of application:
**18.12.85 Bulletin 85/51**

(45) Publication of the grant of the patent:
**10.08.88 Bulletin 88/32**

(84) Designated Contracting States:
**DE FR GB SE**

(56) References cited:
**GB-A-1 132 032**
**US-A-3 843 806**
**US-A-4 182 095**
**US-A-4 394 204**

(73) Proprietor: **N.V. Philips' Gloeilampenfabrieken**
**Groenewoudseweg 1**
**NL-5621 BA Eindhoven (NL)**

(72) Inventor: **Vis, Benjamin**
**c/o INT. OCTROOIBUREAU B.V. Prof. Holstlaan 6**
**NL-5656 AA Eindhoven (NL)**

(74) Representative: **Bos, Kornelis Sjoerd et al**
**INTERNATIONAAL OCTROOIBUREAU B.V. Prof.**
**Holstlaan 6**
**NL-5656 AA Eindhoven (NL)**

Courier Press, Leamington Spa, England.

**Description**

The invention relates to a method for vacuum-packaging a powdered material, which comprises providing first and second gas-impermeable walls and a gas-permeable wall, the three walls being substantially rectangular in shape, the gas-permeable wall being impermeable to the powdered material, introducing the powdered material in the space between the first gas-impermeable wall and the gas-permeable wall, peripherically sealing the gas-permeable wall to the first gas-impermeable wall, extracting gas from the powdered material through the gas-permeable wall by applying a vacuum and peripherally sealing the second gas-impermeable wall to the other two walls while such vacuum continues to be applied.

Such a method is known from US—A—3 843 806. The herein described first gas-impermeable wall. is a package member with upstanding side walls forming a kind of a top open box. First the box is filled with the powdered material and then a gas-permeable wall is peripherally sealed to the edges of the upstanding walls of the box. Next a second gas-impermeable wall is partially sealed to the box and to the gas-permeable wall and thereupon the space containing the powdered material is evacuated through the gas-permeable wall after which the unsealed portion of the second gas-impermeable wall is sealed to the box and to the gas-permeable wall.

The present invention has another starting point, i.e. all the walls forming the package are constituted by sheets and therefore a special method for making the package is necessary.

The object of the invention is to provide a method for vacuum-packaging a powdered material, starting from sheet material and the resulting package having excellent air-tight sealings.

According to the invention the in the introductory paragraph described method is characterised in that all three walls are constituted by sheets of which the gas-permeable sheet has smaller dimensions than the other sheets, said method comprising the following steps:

—centering the gas-permeable sheet on the first gas-impermeable sheet such that said first sheet peripherally overlaps the gas-permeable sheet and sealing one edge of the gas-permeable sheet to the corresponding edge of the first gas-impermeable sheet,

—centering the second gas-impermeable sheet on the opposite side of the gas-permeable sheet such that said second sheet similarly peripherally overlaps the gas-permeable sheet and sealing the three sheets together along their opposed edges perpendicular to the first sealed edge,

—sealing the three sheets together along their corresponding edges opposite the first sealed edge after the powdered material has been introduced in the space between the first gas-impermeable sheet and the gas-permeable sheet, and

—sealing the remaining edge of the second gas-impermeable sheet to the corresponding edges of the other two sheets after extracting gas from the powdered material.

A so made package has the advantage that at the outmost edges only the two gas-impermeable sheets are sealed together, i.e. without interposition of the gas-permeable sheet, and has therefore an excellent air-tight property. This package is very useful as thermal insulation for walls of cooling appliances.

An embodiment of the invention will now be described with reference to the accompanying drawing, of which:

Figure 1 is an exploded view of the three constituent sheets of the container (flexible bag) of the invention before being joined together,

Figure 2 is a partial sectional view on an enlarged scale through one of the outer sheets,

Figure 2A is a front view of the gas-permeable sheet and of the first gas-permeable sheet after they have been joined together by a transverse weld at one edge,

Figure 3 is a front view of the three sheets joined together by further thermo-welding along two opposite longitudinal edges;

Figure 4 is a partial sectional view taken on the line IV—IV of Figure 3, diagrammatically showing the mobile welding bars which form the welds along the longitudinal edges of the sheets;

Figure 5 is a longitudinal sectional view on enlarged scale through the container obtained after the welding operations of Figures 2A, 3 and 4, shown during its filling with the product in the form of fine powder;

Figure 6 shows the container of Figure 5 after welding the product filling mouth and placed in an evacuation hood, but before its final closure.

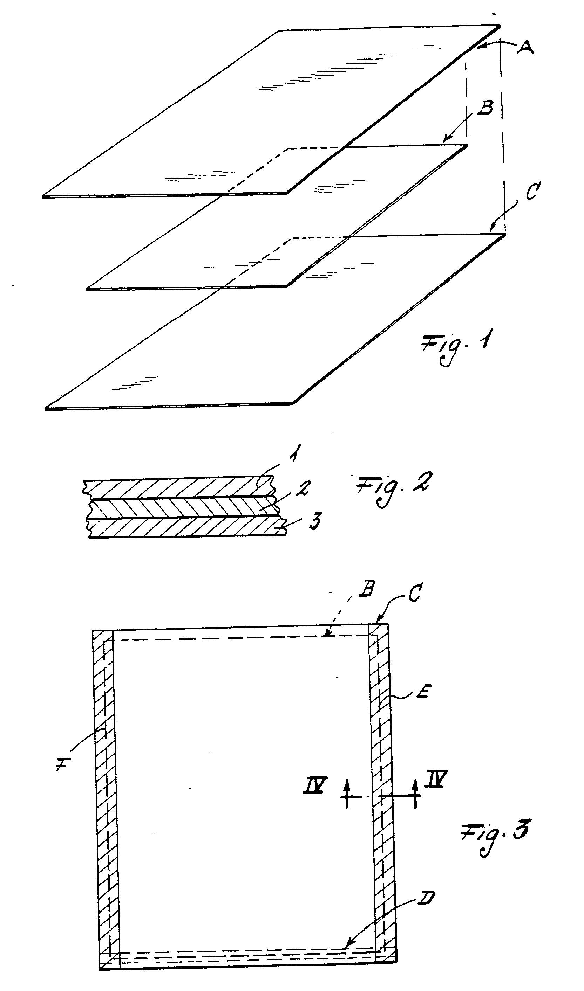

With reference to the figures, the container shown is a bag formed from three rectangular or square sheets A, B and C (Figure 1) which are placed in superposed relationship so that the sheet B is interposed between the other two sheets A, C. The sheet B is of paper or analogous material possessing filtering properties such as to retain the particles of the fed product. A possible example is chemical laboratory filter paper or the paper used in motor vehicle air filters. The other two sheets A and C, preferably of identical nature, must in contrast be impermeable to air so as to enable the vacuum to be retained inside the container, and must be thermoweldable. For example the sheets A and C, which each are shown in greatly enlarged cross-section in Figure 2, are each formed from three layers 1, 2 and 3 of polyethylene, aluminium and nylon respectively, these being joined together by known methods, for example by adhesives. The layer which is to be located internally in the container is the polyethylene layer, i.e. of thermoweldable material. Polyester can be used instead of the nylon, and polypropylene instead of the polyethylene. The layers can also be of a number different from that indicated, and in particular only two in number. Layers have in fact been formed in which the polyethylene thickness was 90 microns, the aluminium thickness 10 microns and the nylon thickness 13 microns.

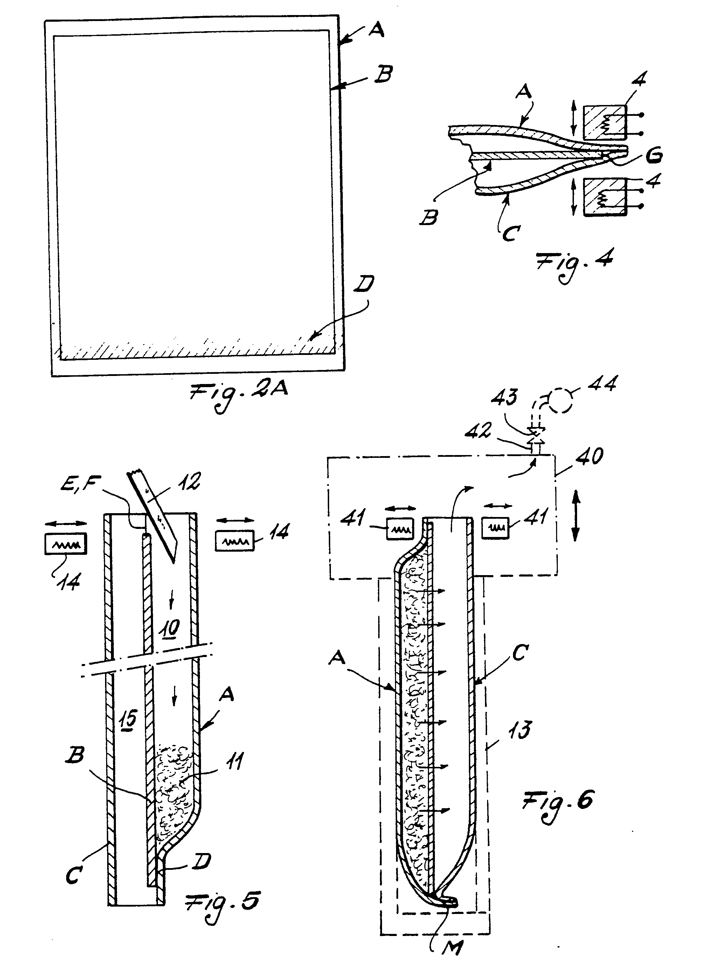

The intermediate filtering sheet B is of slightly smaller dimensions than the other two sheets for the reasons given hereinafter. The sheet B is centered and rested on the thermoweldable layer of one of the other two sheets, for example the sheet A, and is joined to this latter by a thermoweld D shown by a hatching zone in Figure 2A and extending over the entire lower transverse edge of the intermediate sheet B. The thermoweld is made by means of mobile bars 4 such as those shown in Figure 4, which are heated by thermostatically controlled electrical resistance heaters, said bars squeezing together the sheet zones to be welded. The sheet C is then centered on this assembly so that its thermoweldable polyethylene layer rests on the intermediate filtering sheet B. The welding bars 4 are then used to make two thermowelds, indicated by hatching and by the reference letters E and F in Figure 3, which are parallel to each other and extend along the two longitudinal edges of the three sheets to join together all three sheets as shown in crosssection in Figure 4. As the intermediate filtering sheet B is smaller than the other sheets and the welding zones E, F extend over both other parts where the three sheets are superposed and over parts where only the two outer sheets A and C are superposed (again see Figure 4), the edge G of the intermediate sheet does not communicate with the external environment, and instead is sealed therefrom by the projecting ends of the two outer sheets. In this manner it is not possible to lose the vacuum by air infiltration along the edges of the intermediate sheet B which, as stated, is permeable to air.

By means of the described operations, a container is obtained in the form of a flexible bag having a cross-section as shown in Figure 5, and comprising a first upwardly open. chamber 10 defined by the intermediate sheet B and the outer sheet A, and a second chamber 15 open at both ends. The container is placed upright in a mould 13 (see Figure 6) and the finely divided product 11 is loaded into the chamber 10 by any known means, which is here represented diagrammatically by a mobile nozzle 12 connected to a supply of the product. Using a pair of mobile welding bars indicated by 14 in Figure 5, an upper transverse thermoweld M is produced by means of which access to the chamber 10 is closed and the upper end of the chamber 15 is also simultaneously closed, these chambers thus being kept separated only by the intermediate filtering wall B. The transverse weld M is thus made to produce the same results as those described for the two longitudinal welds E, F as shown in Figures 3 and 4.

The resultant container is extracted from the mould 13 and re-inserted therein in an inverted position as shown in Figure 6. By making the mould 13 in the form of two half-moulds joined along a vertical plane and provided with suitably shaped lower edges, the operational stage about to be described can also be carried out while keeping the container (bag) in the same position as during those stages of the method described heretofore, i.e. without inverting it. A movable hood 40 containing a pair of mobile welding bars 41 is placed on this mould in a sealed manner, and is connected by way of a pipe 42 and a control valve 43 to a source of vacuum 44. On opening the valve 43, the space defined by the hood 40 and the mould 13 is put under a vacuum, and the air contained between the particles of the product 11 present in the chamber 10 escapes from this latter through the permeable filtering wall formed by the intermediate sheet B, to reach the upwardly open chamber 15 and to be drawn to the vaccum source 44. After a certain time, and while still maintaining the vacuum, the welding bars 41 are tightened against the upper end of the container to produce a transverse weld extending over the entire width of the container and incorporating the edge of the intermediate sheet B in a manner analogous to that shown in Figure 4. The container is thus hermetically sealed and is ready for use.

To facilitate elimination of air from the product where this is not subject to thermal degradation, the invention also provides the possibility of heating the bag and/or mould which surrounds it, during the evacuation stage. This can be done for example by incorporating resistance heaters in the mould.

One particular aspect of the invention is the application of the container according to the invention as a component or constituent of the thermal insulation of refrigerators, particularly domestic refrigerators, when the product contained in its is in the form of fine powder, the insulating capacity of which depends substantially on the degree of vacuum of the environment in which it is located. Examples of such powder are silica-based powders such as those described in the US—A—4 159 359. In such an application the container or containers of the invention are disposed in the interspace or interspaces between the inner liner and outer housing which define the refrigerator cabinet structure and are secured therein.

## Claims

1. A method for vacuum-packaging a powdered material, which comprises providing first and second gas-impermeable walls (A, C) and a gas-permeable wall (B), the three walls being substantially rectangular in shape, the gas-permeable wall (B) being impermeable to the powdered material,

introducing the powdered material (11) in the space (10) between the first gas-impermeable wall (A) and the gas-permeable wall (B), peripherically sealing the gas-permeable wall (B) to the first gas-impermeable wall (A),

extracting gas from the powdered material through the gas-permeable wall (B) by applying a

peripherally sealing the second gas-impermeable wall (C) to the other two walls (A, B) while such vacuum continues to be applied,

characterised in that all three walls (A, B, C) are constituted by sheets of which the gas-permeable sheet (B) has smaller dimensions than the other sheets (A, C), said method comprising the following steps:

— centering the gas-permeable sheet (B) on the first gas-impermeable sheet (A) such that said first sheet (A) peripherally overlaps the gas-permeable sheet (B) and sealing one edge (D) of the gas-permeable sheet (B) to the corresponding edge of the first gas-impermeable sheet (A),

—centering the second gas-impermeable sheet (C) on the opposite side of the gas-permeable sheet (B) such that said second sheet (C) similarly peripherally overlaps the gas-permeable sheet (B) and sealing the three sheets together along their opposed edges (E, F) perpendicular to the first sealed edge (D),

—sealing the three sheets together along their corresponding edges (M) opposite the first sealed edge (D) after the powdered material (11) has been introduced in the space (10) between the first gas-impermeable sheet (A) and the gas-permeable sheet (B), and

—sealing the remaining edge of the second gas-impermeable sheet (C) to the corresponding edges of the other two sheets (A, B) after extracting gas from the powdered material.

2. A method as claimed in claim 1, characterised in that the resulting partially formed package is heated during application of the vacuum to the gas-permeable sheet.

3. The use of a package made by the method of claim 1 as thermal insulation for cooling appliances.

**Patentansprüche**

1. Verfahren zum Vakuumverpacken eines pulverförmigen Materials, das die folgenden Verfahrensschritte aufweist:

—das Schaffen einer ersten und einer zweiten gasnundurchlässigen Wand (A, C) und einer gasdurchlässigen Wand (B), wobei diese drei Wände im wesentlichen rechteckig sind und wobei die gasdurchlässige Wand (B) für das pulverförmige Material undurchlässig ist,

— das Einführen des pulverförmigen Materials (11) in den Raum (10) zwischen der ersten gasundurchlässigen Wand (A) und der gasdurchlässigen Wand (B),

—das am Umfang Verschweissen der gasdurchlässigen Wand (B) mit der ersten gasundurchlässigen Wand (A),

—das Entgassen des pulverförmigen Materials durch die gasdurchlässige Wand (B) hindurch und zwar dadurch, dass ein Vakuum erzeugt wird und

— das am Umfang Verschweissen der zweiten gasundurchlässigen Wand (C) mit den zwei anderen Wänden (A, B), während das Vakuum nach wie vor beibehalten wird,

dadurch gekennzeichnet, dass die drei Wände (A, B, C) durch Folien gebildet werden, von denen die gasdurchlässige Folie (B) kleiner ist als die anderen Folien (A, C), wobei dieses Verfahren die folgenden Verfahrensschritte aufweist:

— das Zentrieren der gasdurchlässigen Folie (B) auf der ersten gasundurchlässigen Folie (A) und zwar derart, dass die erste Folie (A) am Umfang die gasdurchlässige Folie (B) überlappt und das Verschweissen eines Randes (D) der gasdurchlässigen Folie (B) mit dem entsprechenden Rand der ersten gasundurchlässigen Folie (A),

das Zentrieren der zweiten gasundurchlässigen Folie (C) auf der gegenüberliegenden Seite der gasdurchlässigen Folie (B) und zwar derart, dass diese zweite Folie (C) auf entsprechende Weise am Umfang die gasdurchlässige Folie (B) überlappt und das Verschweissen der drei Folien an ihren einander gegenüberliegenden Rändern (E, F) senkrecht zu dem ersten verschweissten Rand (D),

— das Zusammenschweissen der drei Folien in ihren entsprechenden Rändern (M) gegenüber dem ersten verschweissten Rand (D) nachdem das pulverförmige Material (11) in den Raum (10) zwischen der ersten gasundurchlässigen Folie (A) und der gasdurchlässigen Folie (B) eingeführt worden ist und

— das Verschweissen des letzten Randes der zweiten gasundurchlässigen Folie (C) mit den entsprechenden Rändern der zwei anderen Folien (A, B) nach dem Entgassen des pulverförmigen Materials.

2. Verfahren·nach Anspruch 1, dadurch gekennzeichnet, dass die sich daraus ergebende teilweise gebildete Packung beim Avakuieren durch die gasdurchlässige Folie hindurch erwärmt wird.

3. Die Verwendung einer nach dem Verfahren nach Anspruch 1 hergestellten Packung als thermische Isolierung für Kühlelemente.

**Revendications**

1. Procédé d'emballage sous vide d'un matériau pulvérisé, consistant à former des première et seconde parois imperméables au gaz (A, C) et une paroi perméable au gaz (B), les trois parois étant sensiblement rectangulaires et la paroi perméable au gaz (B) étant imperméable au matériau pulvérisé,

à introduire le matériau pulvérisé (11) dans l'espace (10) séparant la première paroi imperméable au gaz (A) et la paroi perméable au gaz (B),

à sceller la paroi perméable au gaz (B) suivant la périphérie à la première paroi imperméable au gaz (A),

à extraire du gaz du matériau pulvérisé à travers la paroi perméable au gaz (B) en faisant le vide et,

à sceller la seconde paroi imperméable au gaz (C) suivant la périphérie aux deux autres parois (A, B) tout en maintenant le vide,

caractérisé en ce que toutes les trois parois (A, B, C) sont constituées par des feuilles parmi lesquelles la feuille perméable au gaz (B) a des dimensions plus faibles que les autres feuilles, le procédé comportant les étapes suivantes:

—de centrage de la feuille perméable au gaz (B) sur la première feuille imperméable au gaz (A) de façon que cette première feuille (A) chevauche à la périphérie sur la feuille perméable au gaz (B), et de scellement d'un bord (D) de la feuille perméable au gaz (B) au bord correspondant de la première feuille imperméable au gaz (A),

— de centrage de la seconde feuille imperméable au gaz (C) sur la face opposée de la feuille perméable au gaz (B) de façon que, d'une manière analogue, cette seconde feuille (C) chevauche à la périphérie sur la feuille perméable au gaz (B), et de scellement des trois feuilles les unes aux autres suivant leurs bords opposés (E, F) perpendiculaires au premier bord scellé (D),

— de scellement des trois feuilles les unes aux autres suivant leurs bords correspondants (M), situés en face du premier bord scellé (D), après l'introduction du matériau pulvérisé (11) dans l'espace (10) séparant la première feuille imperméable au gaz (A) et la feuille perméable au gaz (B) et

—de scellement du bord restant de la seconde feuille imperméable au gaz (C) aux bords correspondants des deux autres feuilles (A, B) après l'extraction de gaz du matériau pulvérisé.

2. Procédé selon la revendication 1, caractérisé en ce que l'emballage partiellement réalisé est chauffé durant la mise sous vide à travers la feuille perméable au gaz.

3. L'utilisation d'un emballage réalisé par la mise en oeuvre du procédé de la revendication 1 comme isolation thermique pour des appareils frigorifiques.

Fig. 1

Fig. 2

Fig. 3

Fig. 2A

Fig. 4

Fig. 5

Fig. 6

2